(19) **Europäisches Patentamt**

**European Patent Office**

**Office européen des brevets**

(11) **EP 1 357 427 B1**

(12) **EUROPEAN PATENT SPECIFICATION**

(45) Date of publication and mention
of the grant of the patent:
**25.10.2006 Bulletin 2006/43**

(51) Int Cl.:
*G03F 1/14* (2006.01)        *G03F 7/20* (2006.01)

(21) Application number: **03251348.3**

(22) Date of filing: **06.03.2003**

(54) **Mask for use in lithography, lithographic apparatus, and device manufacturing methods**

Lithographische Maske, lithographischer Apparat und Verfahren zur Herstellung einer Vorrichtung

Masque lithographique, appareil lithographique et procédés de fabrication d'un dispositif

(84) Designated Contracting States:
**DE FR GB IT NL**

(30) Priority: **08.03.2002 EP 02251652**

(43) Date of publication of application:
**29.10.2003 Bulletin 2003/44**

(73) Proprietor: **ASML Netherlands B.V.**
**5504 DR Veldhoven (NL)**

(72) Inventors:
• **Eurlings, Markus Franciscus Antonius**
**5045 TH Tilburg (NL)**
• **Van Dijsseldonk, Antonius Johannes Josephus**
**5527 BH Hapert (NL)**
• **Dierichs, Marcel Mathijs Theodore Marie**
**5914 WR Venlo (NL)**

(74) Representative: **Leeming, John Gerard**
**J.A. Kemp & Co.,**
**14 South Square,**
**Gray's Inn**
**London WC1R 5JJ (GB)**

(56) References cited:
**EP-A- 0 757 262          US-A- 5 501 925**
**US-A- 5 641 593          US-A1- 2001 051 304**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

# Description

The present invention relates to masks for use in a lithographic projection apparatus comprising:

- a radiation system for supplying a projection beam of radiation;
- a support structure for supporting a mask serving to pattern the projection beam according to a desired pattern;
- a substrate table for holding a substrate; and
- a projection system for projecting the patterned beam onto a target portion of the substrate.

The mask is an example of "patterning means" which term as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (*e.g.* in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, *e.g.* an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

To reduce the size of features that can be imaged, lithographic apparatus using extreme ultraviolet (EUV) radiation, *e.g.* with a wavelength in the range of from 9 to 16nm, as the exposure radiation are being developed. At these wavelengths, existing techniques for light manipulation are frequently no longer applicable, for example because they require structures that cannot be scaled down sufficiently. Because no material suitable for making refractive optical elements at such wavelengths is known, EUV lithography apparatus use reflective optical systems and also reflective masks. To create a near-normal incidence mirror for EUV having a high-reflectance it is necessary to use a multilayer stack on a substrate, the multilayer comprising alternating layers of materials having contrasting refractive indices and layer thicknesses tuned to the specific wavelength to be employed. To make a mask, or to obscure part of a mirror, a layer of an absorbing material, such as chrome (Cr) or tungsten (W), tantalum (Ta) or a compound such as tantalum-nitride (TaN) is selectively provided on top of the multilayer stack. In the case of a mask, the absorbing layer is generally deposited to cover the whole of the mask and then photo-lithographically processed and etched away to form the mask pattern. An e-beam writer may also be used. The bright areas of such a mask typically reflect about 65% of the incident radiation whilst the dark areas reflect less than 0.5%, providing a high contrast. However, if multiple exposures of a dark area overlap, the cumulative dose received by the substrate can be sufficient to cause an undesirable loss of contrast. This can occur when exposing a so-called Focus-Energy Matrix (FEM) for calibration purposes or when exposing a large number of closely packed small dies without reticle masking blades.

US-A-2001 051304 describes a reflective mask having non-reflective and reflective regions. The reflective regions are reflective of light at both an inspection wavelength and a semiconductor processing wavelength and the non-reflective regions are substantially non-reflective of light at the same inspection and semiconductor processing wavelengths. Processing steps are described whereby the surface of the absorbing material in the non-reflective region is roughened in order to scatter reflected inspection wavelength light away from a collection lens.

US-A-5 501 925 describes a transparent phase reticle mask which consists of a first portion for scattering incident light beyond the solid angle of an image system and a second portion where projection of incident light by an imaging system can occur. The aim is to improve over masks in which the non-transmitting portion simply blocks light, since with high intensity sources such masks are rapidly degraded. Two solutions are proposed for the scattering portion of the mask. The first is a phase-grating that diffracts incident light beyond the lens of the imaging system. The second approach is to phase-roughen the surface, so that the majority of incident light is scattered away from the imaging system.

Objects of the present invention are to avoid or alleviate problems due to loss of contrast caused by radiation reflected firstly by the dark parts of a mask and secondly by other absorbing layers in a lithographic apparatus.

The first and other objects are achieved according to the invention in a reflective mask for use in a lithographic apparatus as specified in the opening paragraph, said mask having areas of relatively high reflectance and areas of relatively low reflectance defining a mask pattern having a smallest printing feature size, wherein:

> said areas of low reflectance comprise a layer having a texture at a scale smaller than said smallest printing feature size such that specular reflection from said areas of low reflectance is reduced, and characterized in that said texture comprises a phase grating.

By providing the texture on the areas of low reflectance (dark areas), the specular reflection from these areas is reduced, as compared to the case if the dark areas were smooth. In the past, the absorbent layer in a mask has been deposited by methods which provide an optically smooth (at the wavelength of the projection beam) upper surface and the dark areas are protected by resist during subsequent etching to form the mask pattern. The dark areas therefore remain smooth. Therefore, a high proportion of the projection system and is directed onto the substrate. The texture applied according to the invention has a scale smaller than the smallest feature size in the mask pattern and spoils that optical smoothness so reducing the specular reflection from the dark areas. It should be noted that the texture may be on a scale sufficiently small compared to the wavelength of visible light that the dark areas will still appear smooth to the naked eye.

It is well known that a mask may have printing features, i.e. features that will be printed when the mask is used in a lithographic process, as well as non-printing features, also referred to as sub-resolution features, that do not appear directly in the printed pattern but affect the shape and/or position of the printed features. Such features include optical proximity correction elements, serifs, scattering bars, etc. The texture of the invention must have a smaller scale than the printing features but not necessarily smaller than the non-printing features.

In a preferred embodiment of the invention, the texture comprises a phase grating. Preferably the grating comprises lands and recesses causing a relative phase shift of substantially $\pi$ radians, which can be achieved by providing a height difference between the lands and recesses substantially equal to one quarter of the wavelength of the exposure radiation.

It is preferably that the lands and recesses each occupy close to 50% of the total area of the areas of relatively low reflectance to provide maximum suppression of the specular reflection.

The pitch of such a phase grating is preferably chosen so that the first order (and higher) diffracted beams lie outside the pupil of the projection system. In this way the undesired light entering the projection system can be reduced to substantially zero. Accordingly, the pitch, $p$, of the phase grating at substrate level should satisfy the inequality:

$$p < \frac{\lambda}{(1+\sigma).NA.|M|}$$

where $\lambda$ is the wavelength of the exposure radiation and $NA$, $M$ and $\sigma$ are respectively the numeric aperture, magnification and pupil filling ratio of the projection system. If the pupil filling ratio to be used is not known when the mask is made, it can be assumed to be 1 to ensure the first order lies outside the pupil of the projection system.

The exact form of the grating may depend on the mask pattern. Preferably, the grating is two-dimensional to avoid undesired effects that may occur if lines of a one-dimensional grating were to line up with linear features of the mask pattern. However, for mask patterns with no linear features or linear features extending in only one or a limited number or range of directions, a one-dimensional grating structure that crosses the lines of the mask pattern may be employed.

In an alternative embodiment of the present invention, the dark areas are treated to act as a diffuser for diffusing the reflected radiation into a large solid angle. This will still reflect some radiation into the projection system but the larger the solid angle into which the radiation is diffused, the smaller the fraction entering the projection system. To act as a diffuser, a random or pseudo-random pattern may be applied to the absorbing layer. This may be accomplished by chemical or mechanical roughening of the surface of the absorbing layer or by suitable manipulation of the deposition process, *e.g.* by introduction of contaminants. It is possible to construct the absorbing layer so that additional scattering occurs throughout the interior of the layer. Layers of relatively large thickness are more effective in this regard but introduce undesirable defocussing effects. A solution is to make the absorbing layer granular in order to achieve a large number of internal boundaries which increase the scattering.

Materials that are particularly effective as absorbing layers are tantalum (Ta) and tantalum-nitride (TaN).

The present invention also provides a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material using a projection system;

wherein said step of using patterning means comprises positioning a mask having areas of relatively high reflectance and areas of relatively low reflectance defining said pattern; wherein:

said areas of low reflectance comprise a layer having a surface texture at a scale smaller than the smallest printing feature in said pattern resolvable on said substrate by said projection system, and characterized in that said texture comprises a phase grating.

The second object of the invention is achieved in a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;

an optical element included in said radiation system or said projection system, at least a part of which is provided with an absorbing layer; wherein:

said absorbing layer of said optical element is provided with a texture at a scale smaller than the smallest feature size resolvable by said projection system such that specular reflection from said absorbing layer is reduced, and characterized in that said texture comprises a phase grating.

In this way, the same inventive concept that is applied to masks, may be used to reduce unwanted reflections from other optical elements that are at least partly absorbing. Such elements may include mirrors in the radiation system that are partially obscured to define the beam shape, the illumination field shape or other illumination settings, blades for masking areas of another optical element, such as a reticle, as well as spatial filters, pupil or aperture stops and blades for defining the numeric aperture.

According to a further aspect of the invention there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material; and

absorbing a part of said projection beam in an absorbing layer provided on an optical element, said absorbing layer of said optical element being provided with a texture at a scale smaller than the smallest feature size resolvable by said projection system such that specular reflection from said absorbing layer is reduced, and characterized in that said texture comprises a phase grafting.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams; such as ion beams or electron beams.

Embodiments of the invention will now be described, by way of example only, with reference to the accompanying schematic drawings in which:

Figure 1 depicts a lithographic projection apparatus in which masks according to embodiments of the invention may be used;
Figure 2 depicts an example of a mask pattern used in explaining the function of the invention;
Figure 3 depicts a sub-resolution pattern applied to a mask according to an embodiment of the present invention;
Figure 4 depicts the mask pattern of Figure 2 overlaid on the sub-resolution pattern of Figure 3;
Figure 5 is a diagram used in explaining how a mask according to the first embodiment functions;
Figure 6 is a graph showing the relative power in the specular reflection as a function of the duty ratio and the phase step of the sub-resolution pattern;
Figures 7 and 8 show first and second standing wave patterns used to expose a resist in a method of making a mask according to an embodiment of the present invention;
Figure 9 shows the combined image resulting from the exposures of the standing wave patterns of Figures 7 and 8; and
Figures 10 to 13 illustrate steps in a method of making a mask according to an embodiment of the present invention; and
Figure 14 is a diagram used in explaining how a mask according to a second embodiment of the invention functions.

In the Figures, corresponding reference symbols indicate corresponding parts.

Embodiment 1

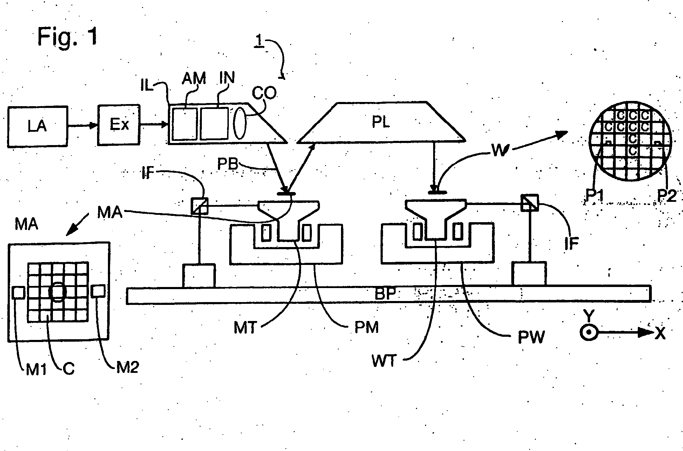

Figure 1 schematically depicts a lithographic projection apparatus in which a mask according to a particular embodiment of the invention may be used. The apparatus comprises:

a radiation system Ex, IL, for supplying a projection beam PB of radiation (*e.g* EUV radiation), which in this particular case also comprises a radiation source LA;
a first object table (mask table) MT provided with a mask holder for holding a mask MA (*e.g.* a reticle), and connected to first positioning means for accurately positioning the mask with respect to item PL;
a second object table (substrate table) WT provided with a substrate holder for holding a substrate W (*e.g.* a resist-coated silicon wafer), and connected to second positioning means for accurately positioning the substrate with respect to item PL;
a projection system ("lens") PL (*e.g.* a mirror group) for imaging an irradiated portion of the mask MA onto a target portion C (*e.g.* comprising one or more dies) of the substrate W.

As here depicted, the apparatus is of a reflective type (*i.e.* has a reflective mask). However, in general, it may also be of a transmissive type, for example (with a transmissive mask).

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as o-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (*e.g.* with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or 1/5). In this manner, a relatively large target portion C can be exposed, without having to compromise on resolution.

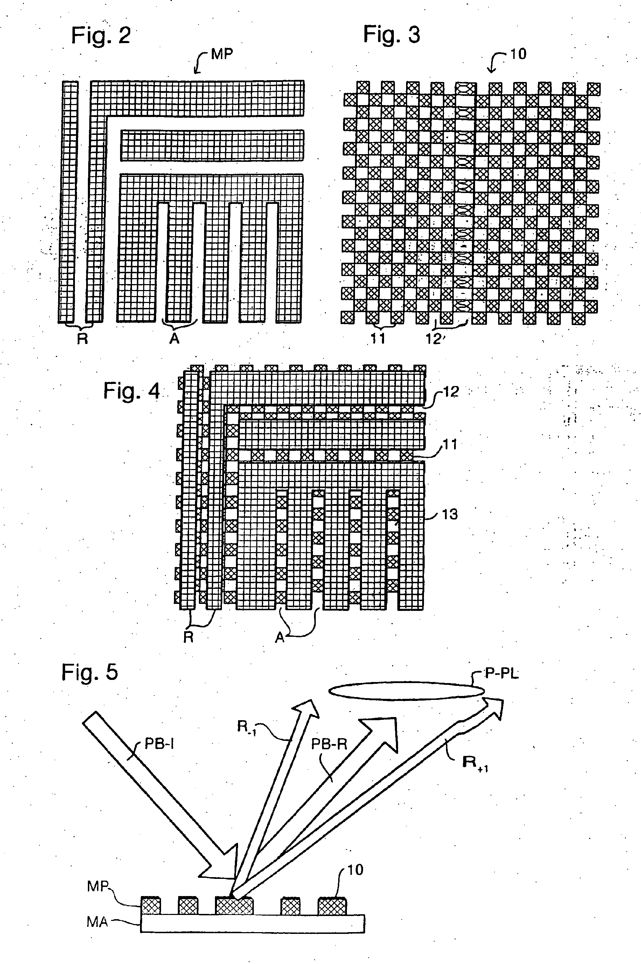

The mask MA has a mask pattern MP defined by a plurality of reflective and absorbing areas R, A, as shown, by way of example, in Figure 2. Such a mask may be formed by removing, *e.g.* by etching, in the reflective areas R an absorbing layer provided on top of a multilayer stack optimized for reflection at the expected angle of incidence and wavelength of the projection beam. The absorbing areas A are where the absorbing layer is left behind.

According to the first embodiment of the present invention, the surface of the absorbing layer is provided with a texture 10 formed by lands 11 and recesses 12 in a checkerboard pattern, as shown in Figure 3. The lands 11 and recesses 12 have a pitch smaller than the smallest feature size appearing in the mask pattern and/or resolvable by the projection system PL at substrate level and generally speaking are arranged in a two-dimensional pattern to form a two-dimensional phase grating. To maximize the phase contrast, the height difference between the lands 11 and recesses 12 is preferably substantially one quarter of the wavelength of the radiation of the projection beam PB.

Figure 4 shows the result of the combination of the mask pattern MP and sub-resolution phase grating 10. In the reflective areas R, the multilayer stack is revealed whilst in the absorbing areas A, the sub-resolution pattern 10 can be seen on the surface of the absorbing layer. It should be noted that the exact shape, position and orientation of the sub-resolution pattern 10 is not important provided that at least a one-dimensional phase-contrast grating is apparent in each of absorbing areas A. It will be appreciated that the texture and mask pattern are not shown to scale in Figures 2, 3 and 4

Figure 5 illustrates how the mask according to the second embodiment of the invention functions. (It should be noted that the angles shown in Figure 5 are purely chosen for illustrative purposes and in an actual embodiment of the invention the projection beam will be incident at an angle much closer to the normal.) The projection beam PB-I is projected onto the mask MA by illumination system IL and reflected to form patterned projection beam PB-R which enters the pupil of the projection lens system P-PL. The majority of the energy in the projection beam PB-I that is incident on the absorbing areas A in the mask pattern MP is absorbed. Some energy is however reflected. Because of the phase-contrast grating 10 provided on the upper surface of the absorbing areas A, the radiation reflected by the absorbing areas A is diffracted rather than simply specularly reflected. By ensuring that the ratio of the total areas of lands 11 and of recesses 12 is as close a possible to 1 and that the relative phase difference between radiation reflected from the lands and from the recesses is $\pi$ radians, the $0^{th}$-order beam (specular reflection) is suppressed and substantially all of the radiation is directed into the $1^{st}$-order diffracted beams $R_{-1}$, $R_{+1}$ and higher orders. The radiation reflected from the absorbing areas A is thus spatially separated from the patterned projection beam PB-R. By appropriate choice of the pitch of the phase-contrast grating 10 it can be ensured that the $1^{st}$ (and higher)-order diffracted beams lie outside the pupil of the projection lens P-PL and so are not imaged on the substrate. The dose delivered to dark areas of the substrate is therefore substantially reduced.

From the diffraction equation, it can be derived that for the $1^{st}$ orders to lie outside the pupil of the projection system, the pitch $p$ of the sub-resolution pattern 10, must satisfy the following inequality:

$$p \leq \frac{\lambda}{(1+\sigma) \cdot NA \cdot |M|}$$

where $\lambda$ is the wavelength of the exposure radiation in projection beam PB, and $\sigma$, *NA* and *M* are respectively the pupil filling ratio, numeric aperture and magnification of the projection system PL.

As mentioned above, it is desirable to entirely suppress the specular reflection from the absorbing areas A which is achieved by arranging for the phase difference $\Delta\varphi$ between the radiation reflected from the lands 11 and from the recesses 12 to be equal to $\pi$ radians and for the ratio of total area of lands to total area of recesses to be 1. The latter condition may also be expressed as the phase-contrast grating having a duty ratio DR of 0.5.

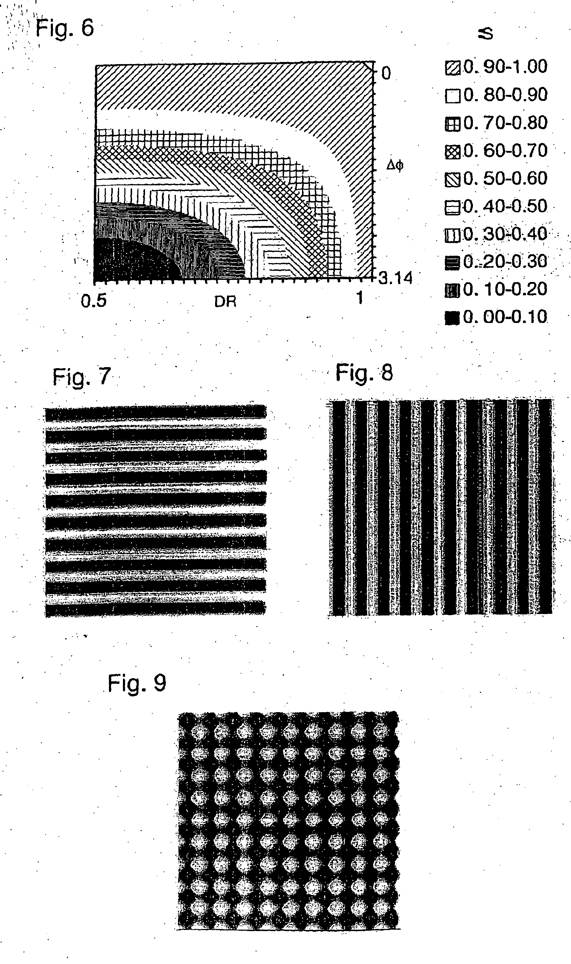

Nevertheless, a substantial and desirable reduction in the power contained in the specular reflection can be achieved even if the phase difference $\Delta\varphi$ and duty ratio DR deviate substantially from their ideal values. Figure 6 shows the proportion S of the total power reflected by absorbing areas A that is contained in the specular reflection as a function of the phase difference $\Delta\varphi$ and the duty ratio DR of the phase grating 10. It can be seen that a relatively large phase error, within $\pm$ $\pi/5$ of the ideal phase step of $\pi$, still results in 90% attenuation of the $0^{th}$-order. Such a phase error is equivalent to a 0.7nm depth error on a step of 3.4nm, for $\lambda$ = 13.5nm. Thus, the present invention can provide substantial advantages even with relatively high tolerances in the manufacture of the phase-contrast grating 10.

A suitable phase-contrast grating 10 can be formed relatively simply by etching the checkerboard pattern, as shown in Figure 3, in the top surface of the absorbing layer before that is selectively removed to form the mask pattern MP. To do this, it is first necessary to expose a resist layer provided in top of the absorbing layer in a suitable pattern. It is known to expose a resist to form a linear grating by irradiating it with two coherent beams of radiation which are mutually inclined so that interference between the two beams forms a standing wave pattern in the resist. Figure 7 shows the intensity distribution of such a standing wave pattern. The pitch of this pattern is determined by the wavelength of the radiation used for the exposure and the angle of inclination of the two beams. According to the invention, the resist is also exposed with a second standing wave pattern, shown in Figure 8, oriented at 90° to the first standing wave pattern giving a total exposure as shown in Figure 9. The angle between the two standing wave patterns can be less than 90°, which will result in a grating having different pitches in orthogonal directions - this is acceptable provided the layer of the pitches is sufficiently small. It will be appreciated that the complete exposure can be effected in one step using four beams or in two steps using two beams and a relative rotation between the beams and the mask blanks between steps.

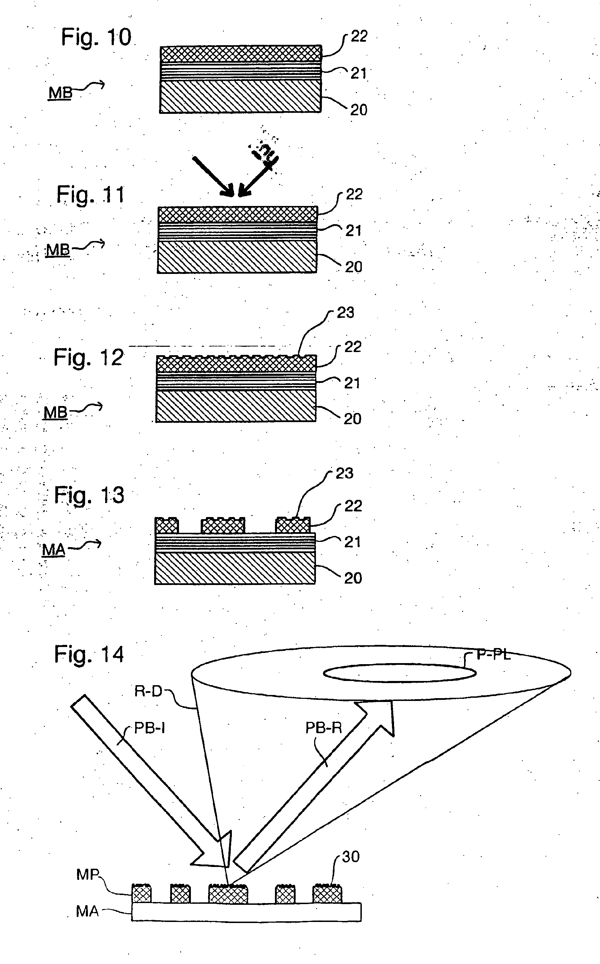

Figures 10 to 13 show the complete process. The initial mask blank MB. shown in Figure 10 comprises a. substrate 20, multilayer stack 21 optimized for reflectivity at the wavelength of the projection radiation and absorbing layer 22 which covers the entire upper surface of the mask blank MB. This is initially coated with a resist (not shown) which is exposed as described above with orthogonal standing wave patterns. The exposed resist is developed to form a checkerboard pattern and the exposed areas of the absorbing layer 22 are etched to a depth equal to one quarter of the wavelength of the radiation of the projection beam so as to define a surface pattern 23, as shown in Figure 12.

To create the mask pattern MP, the absorbing layer is again covered by a resist which is exposed to define the mask pattern, *e.g.* using projection lithography or an e-beam direct writer. The resist is developed and the absorbing layer 22 etched away completely to form the reflective areas of the mask pattern MP. Thus, the mask MA as shown in Figure 13 has areas where the multilayer stack 21 is exposed and areas where it is covered by absorbing layer 22, which retains a sub-resolution pattern 23 in its upper surface.

The surface pattern may of course be formed by other processes and may be formed at the same time as the mask pattern or in advance on a mask blank. Other processes to form the surface pattern include exposing a resist with a suitable pattern (using for example a lithographic apparatus, an e-beam direct writer, an ion-beam direct writer or by X-ray contact or proximity printing) then developing the resist and etching the underlying absorbing layer. The surface pattern can also be formed directly in the absorbing layer by such techniques as embossing or ion-beam etching.

Embodiment 2

In a second embodiment of the present invention, which is the same as the first embodiment save as described below, the texture applied to the absorbing layer forms a diffuser rather than a phase-contrast grating. The functioning of mask according to the second embodiment of the present invention is shown in Figure 14.

As in the first embodiment, the incident projection beam is patterned and reflected by the mask pattern MP provided on the mask MA and the patterned, reflected beam PB-R is captured by the pupil P-PL of the projection system. The radiation reflected from the dark areas is diffused into a cone R-D having a large solid angle compared to the numerical aperture of the projection system PL by the action of the diffuser formed by the texture 30 in the absorbing areas of the mask pattern. Clearly, in this embodiment of the invention, some light reflected from the dark areas of the pattern does enter the projection system PL but the proportion doing so can be reduced substantially by arranging that the solid angle into which light is diffused is as large as possible.

To act as a diffuser, the texture of the absorbing layer could be given a random or pseudo-random texture. This can be achieved lithographically or by chemical or mechanical: roughening of the surface of the absorbing layer before the mask pattern MP is formed. It is also possible .to provide the necessary roughness by appropriate manipulation of the creation, *e.g.* by deposition, of the absorbing layer. The absorbing layer may be designed to cause scattering internally as well as at the surface. This can be achieved by introducing a large number of optical boundaries, i.e. changes in refractive index, into the interior of the absorbing layer, possibly by making the absorbing layer granular.

Where the absorbing layer is formed by deposition the roughness can be achieved by manipulation of such parameters as the pressure and temperature of the deposition process as well as the evaporation or sputtering rate or by the introduction of contaminants.

The appropriate degree of roughness to produce the desired effect can be determined from the following equation:

$$F = 1 - \exp\left[-\left(\frac{4\pi}{\lambda}\right)^2 \sigma^2\right]$$

where $F$ is the proportion of the incident radiation that is diffusely, rather than specularly, reflected, $\lambda$ is the wavelength of the radiation and $\sigma$ the rms surface roughness. For radiation at 13.5, an rms surface roughness of 1nm gives 57% diffuse reflection whilst 2nm gives 97% flare.

Whilst specific embodiments of the invention have been described above, it will be appreciated that the invention may be practiced otherwise than as described. The description is not intended to limit the invention.

**Claims**

1. A reflective mask (MA) for use in a lithographic apparatus, said mask (MA) having areas of relatively high reflectance (R) and areas of relatively low reflectance (A) defining a mask pattern having a smallest printing feature size, wherein:

   said areas of low reflectance (A) comprise a layer having a texture at a scale smaller than said smallest printing feature size such that specular reflection from said areas of low reflectance (A) is reduced, and **characterized in that** said texture comprises a phase grating (10).

2. A mask according to claim 1 wherein said grating (10) comprises lands (11) and recesses (12) such that there is a phase shift of substantially $\pi$ radians between exposure radiation reflected from the lands (11) and from the valleys (12).

3. A mask according to claim 2 wherein the ratio of the total area of said lands (11) to the total area of said recesses (12) is in the range of from 2/3 to 3/2.

4. A mask according to claim 1, 2 or 3 wherein said phase grating (10) has a pitch such that the first order diffracted beams lie outside the pupil of the projection system (PL) of the lithographic apparatus.

5. A mask according to claim 1, 2, 3 or 4 wherein said grating (10) is two-dimensional.

6. A mask according to any of the preceding claims wherein said layer is formed from tantalum (Ta) and/or tantalum-nitride (TaN).

7. A mask according to claim 6 wherein said texture has an rms roughness of greater than or equal to 1 nm.

8. A device manufacturing method comprising the steps of:

   - providing a substrate (W) that is at least partially covered by a layer of radiation-sensitive material;
   - providing a projection beam (PB) of radiation using a radiation system;
   - using patterning means to endow the projection beam (PB) with a pattern in its cross-section;
   - projecting the patterned beam (PB) of radiation onto a target portion of the layer of radiation-sensitive material using a projection system (PL);

   wherein said step of using patterning means comprises positioning a mask (MA) having areas of relatively high reflectance (R) and areas of relatively low reflectance (A) defining said pattern; wherein:

   said areas of low reflectance (A) comprise a layer having a surface texture at a scale smaller than the smallest printing feature in said pattern resolvable on said substrate (W) by said projection system (PL), and **characterized in that** said texture comprises a phase grating (10).

9. A method according to claim 8 wherein said phase grating (10) comprises lands (11) and recesses (12) such that there is a phase shift of substantially $\pi$ radians between radiation of the projection beam reflected (PB) from the lands (11) and from the recesses (12).

10. A method according to claim 8 or 9 wherein said phase grating (10) has a pitch, $p$, that satisfies the following inequality:

$$p < \frac{\lambda}{(1+\sigma).NA.|M|}$$

where λ is the wavelength of the radiation of the projection beam (PB) and σ, *NA* and *M* are respectively the pupil filling ratio, the numeric aperture and the magnification of said projection system (PL).

11. A lithographic projection apparatus comprising:

> - a radiation system for supplying a projection beam (PB) of radiation;
> - a support structure for supporting patterning means, the patterning means serving to pattern the projection beam (PB) according to a desired pattern;
> - a substrate table(WT) for holding a substrate (W);
> - a projection system (PL) for projecting the patterned beam onto a target portion of the substrate (W);
> an optical element included in said radiation system or said projection system (PL), at least a part of which is provided with an absorbing layer (22); wherein:
>
>> said absorbing layer (22) of said optical element is provided with a texture at a scale smaller than the smallest feature size resolvable by said projection system (PL) such that specular reflection from said absorbing layer (22) is reduced, and **characterized in that** said texture comprises a phase grating (23).

12. A device manufacturing method comprising the steps of:

> - providing a substrate (W) that is at least partially covered by a layer of radiation-sensitive material;
> - providing a projection beam (PB) of radiation using a radiation system;
> - using patterning means to endow the projection beam (PB) with a pattern in its cross-section;
> - projecting the patterned beam of radiation onto a target portion of the layer of radiation-sensitive material; and
> absorbing a part of said projection beam (PB) in an absorbing layer (22) provided on an optical element, said absorbing layer (22) of said optical element being provided with a texture at a scale smaller than the smallest feature size resolvable by said projection system (PL) such that specular reflection from said absorbing layer (22) is reduced, and **characterized in that** said texture comprises a phase grating (23).

**Patentansprüche**

1. Reflektierende Maske (MA) zur Verwendung in einer lithographischen Vorrichtung, wobei die Maske (MA) Bereiche mit relativ hohem Reflexionsgrad (R) und Bereiche mit relativ niedrigem Reflexionsgrad (A) aufweist, die ein Maskenmuster mit kleinster Druckstrukturgröße definieren, wobei:

> die Bereiche mit niedrigem Reflexionsgrad (A) eine Schicht aufweisen, deren Textur um eine Größenordnung kleiner ist als die kleinste Druckstrukturgröße, so dass eine gerichtete Reflexion von den Bereichen mit niedrigem Reflexionsgrad (A) reduziert wird, und **dadurch gekennzeichnet, dass** die besagte Textur ein Phasengitter (10) umfasst.

2. Maske nach Anspruch 1, wobei das Gitter (10) Stege (11) und Aussparungen (12) derart aufweist, dass eine Phasenverschiebung von im wesentlichen π-Radianten zwischen der Belichtungsstrahlung gegeben ist, die von den Stegen (11) und den Aussparungen (12) reflektiert wird.

3. Maske nach Anspruch 2, wobei das Verhältnis der Gesamtfläche der Stege (11) zur Gesamtfläche der Aussparungen (12) zwischen 2/3 bis 3/2 liegt.

4. Maske nach Anspruch 1, 2 oder 3, wobei das Phasengitter (10) einen derartigen Abstand aufweist, dass die gebeugten Strahlen erster Ordnung außerhalb der Pupille des Projektionssystems (PL) der lithographischen Vorrichtung liegen.

5. Maske nach Anspruch 1, 2, 3 oder 4, wobei das Gitter (10) zweidimensional ist.

6. Maske nach einem der vorhergehenden Ansprüche, wobei die Schicht aus Tantal (Ta) und/oder Tantal-Nitrid (TaN) gebildet ist.

7. Maske nach Anspruch 6, wobei die Textur eine rms-Rauigkeit aufweist, die größer oder gleich 1nm ist.

8. Verfahren zum Herstellen von Bauelementen, das folgende Schritte umfasst:

> - Bereitstellen eines Substrats (W), das zumindest teilweise von einer Schicht aus strahlungsempfindlichem Material bedeckt ist;
> - Bereitstellen eines Projektionsstrahls (PB) aus Strahlung unter Verwendung eines Strahlungssystems;
> - Verwenden von Musteraufbringungseinrichtungen, um den Projektionsstrahl (PB) in seinem Querschnitt mit einem Muster zu versehen;
> - Projizieren des gemusterten Strahls (PB) aus Strahlung auf einen Zielabschnitt der Schicht aus strahlungsempfindlichem Material unter Verwendung eines Projektionssystems (PL);

wobei der Schritt des Verwendens von Musteraufbringungseinrichtungen das Positionieren einer Maske (MA) umfasst, die Bereiche mit relativ hohem Reflexionsgrad (R) und Bereiche mit relativ niedrigem Reflexionsgrad (A) aufweist, die das Muster definieren; wobei

die Bereiche mit niedrigem Reflexionsgrad (A) eine Schicht aufweisen, die um eine Größenordnung kleiner als die kleinste Druckstruktur in dem Muster ist, die auf dem Substrat (W) durch das Projektionssystem (PL) aufgelöst werden kann, und **dadurch gekennzeichnet, dass** die Textur ein Phasengitter (10) umfasst.

9. Verfahren nach Anspruch 8, wobei das Phasengitter (10) Stege (11) und Aussparungen (12) derart aufweist, dass eine Phasenverschiebung von im wesentlichen $\pi$-Radianten zwischen der Strahlung des Projektionsstrahls (PB) gegeben ist, die von den Stegen (11) und den Aussparungen (12) reflektiert wird.

10. Verfahren nach Anspruch 8 oder 9, wobei das Phasengitter (10) einen Abstand $p$ aufweist, der folgende Ungleichheit erfüllt:

$$p < \frac{\lambda}{(1+\sigma).NA.|M|}.$$

wobei $\lambda$ die Wellenlänge der Strahlung des Projektionsstrahls (PB) ist und $\sigma$, $NA$ und $M$ jeweils das Pupillenfüllverhältnis, die numerische Apertur und die Vergrößerung des Projektionssystems (PL) sind.

11. Lithographische Projektionsvorrichtung, mit:

- einem Strahlungssystem zur Bereitstellung eines Projektionsstrahls (PB) aus Strahlung;
- einer Haltekonstruktion zum Halten von Musteraufbringungseinrichtungen, wobei die Musteraufbringungseinrichtungen dazu dienen, den Projektionsstrahl (PB) gemäß einem gewünschten Muster zu mustern;
- einem Substrattisch (WT) zum Halten eines Substrats (W);
- einem Projektionssystem (PL) zum Projizieren des gemusterten Strahls auf einen Zielabschnitt des Substrats (W);
- einem optischen Element, das in dem Strahlungssystem oder dem Projektionssystem (PL) enthalten ist, wobei wenigstens ein Teil davon mit einer absorbierenden Schicht (22) versehen ist; wobei;

die absorbierende Schicht (22) des optischen Elements mit einer Textur versehen ist, die um eine Größenordnung kleiner ist als die kleinste Strukturgröße, die von dem Projektionssystem (PL) aufgelöst werden kann, so dass eine gerichtete Reflexion von der absorbierenden Schicht (22) reduziert wird, und **dadurch gekennzeichnet, dass** die Textur ein Phasengitter (23) umfasst.

12. Verfahren zum Herstellen von Bauelementen, das folgende Schritte umfasst:

- Bereitstellen eines Substrats (W), das zumindest teilweise von einer Schicht aus strahlungsempfindlichem Material bedeckt ist;
- Bereitstellen eines Projektionsstrahls (PB) aus Strahlung unter Verwendung eines Strahlungssystems;
- Verwenden von Musteraufbringungseinrichtungen, um den Projektionsstrahl (PB) in seinem Querschnitt mit einem Muster zu versehen;
- Projizieren des gemusterten Strahls aus Strahlung auf einen Zielabschnitt der Schicht aus strahlungsempfindlichem Material; und
- Absorbieren eines Teils des Projektionsstrahls (PB) in einer absorbierenden Schicht (22), die auf einem optischen Element bereitgestellt ist, wobei die absorbierende Schicht (22) des optischen Elements mit einer Textur versehen ist, die um eine Größenordnung kleiner ist, als die kleinste Strukturgröße, die von dem Projektionssystem (PL) aufgelöst werden kann, so dass eine gerichtete Reflexion von der absorbierenden Schicht (22) reduziert wird, und **dadurch gekennzeichnet, dass** die Textur ein Phasengitter (23) umfasst.

**Revendications**

1. Masque réflecteur (MA) destiné à être utilisé dans un appareil lithographique, ledit masque (MA) ayant des zones de réflectance relativement élevée (R) et des zones de réflectance relativement faible (A) définissant un motif de masque ayant une plus petite taille de caractéristique d'impression, dans lequel :

lesdites zones de faible réflectance (A) comportent une couche ayant une texture à une échelle plus petite que ladite plus petite taille de caractéristique d'impression de sorte qu'une réflexion spéculaire à partir desdites zones de faible réflectance (A) est réduite, et **caractérisé en ce que** ladite texture comporte une grille de phase (10).

**2.** Masque selon la revendication 1, dans lequel ladite grille (10) comporte des îlots (11) et des creux (12) de telle sorte qu'il y a un déphasage de sensiblement π radians entre un rayonnement d'exposition réfléchi à partir des îlots (11) et à partir des creux (12).

**3.** Masque selon la revendication 2, dans lequel le rapport de la surface totale desdits îlots (11) sur la surface totale desdits creux (12) est dans l'intervalle de 2/3 à 3/2.

**4.** Masque selon la revendication 1, 2 ou 3, dans lequel ladite grille de phase (10) a un pas tel que les faisceaux diffractés du premier ordre se trouvent à l'extérieur de la pupille du système de projection (PL) de l'appareil lithographique.

**5.** Masque selon la revendication 1, 2, 3 ou 4, dans lequel ladite grille (10) est bidimensionnelle.

**6.** Masque selon l'une quelconque des revendications précédentes, dans lequel ladite couche est formée de tantale (Ta) et/ou de nitrure de tantale (TaN).

**7.** Masque selon la revendication 6, dans lequel ladite texture a une rugosité rms (quadratique moyenne) supérieure ou égale à 1 nm.

**8.** Procédé de fabrication d'un dispositif comportant les étapes consistant à :

- fournir un substrat (W) qui est au moins partiellement revêtu d'une couche de matériau sensible à un rayonnement ;
- fournir un faisceau de projection (PB) d'un rayonnement en utilisant un système de rayonnement ;
- utiliser des moyens de formation de motif pour doter le faisceau de projection (PB) d'un motif dans sa coupe transversale ;
- projeter le faisceau muni d'un motif (PB) de rayonnement sur une partie cible de la couche de matériau sensible à un rayonnement en utilisant un système de projection (PL) ;

dans lequel ladite étape d'utilisation des moyens de formation de motif comporte le positionnement d'un masque (MA) ayant des zones de réflectance relativement élevée (R) et des zones de réflectance relativement faible (A) définissant ledit motif ; dans lequel :

lesdites zones de faible réflectance (A) comportent une couche ayant une texture superficielle à une échelle plus petite que la plus petite caractéristique d'impression dudit motif résoluble sur ledit substrat (W) par ledit système de projection (PL), et **caractérisé en ce que** ladite texture comporte une grille de phase (10).

**9.** Procédé selon la revendication 8, dans lequel ladite grille de phase (10) comporte des îlots (11) et des creux (12) de telle sorte qu'il y a un déphasage de sensiblement π radians entre un rayonnement du faisceau de projection réfléchi (PB) à partir des îlots (11) et à partir des creux (12).

**10.** Procédé selon la revendication 8 ou 9, dans lequel ladite grille de phase (10) a un pas, p, qui satisfait à l'inégalité suivante :

$$p < \frac{\lambda}{(1 + \sigma).NA.|M|}$$

où λ est la longueur d'onde du rayonnement du faisceau de projection (PB) et σ, NA et M sont respectivement le rapport de remplissage de pupille, l'ouverture numérique et le grossissement dudit système de projection (PL).

**11.** Appareil de projection lithographique comportant :

- un système de rayonnement pour fournir un faisceau de projection (PB) de rayonnement ;
- une structure de support pour supporter des moyens de formation de motif, les moyens de formation de motif servant à munir d'un motif le faisceau de projection (PB) conformément à un motif voulu ;
- une table de substrat (WT) pour supporter un substrat (W) ;
- un système de projection (PL) pour projeter le faisceau muni d'un motif sur une partie cible du substrat (W) ;
- un élément optique inclus dans ledit système de rayonnement ou ledit système de projection (PL), dont au moins une partie est munie d'une couche absorbante (22) ; dans lequel :

ladite couche absorbante (22) dudit élément optique est munie d'une texture à une échelle plus petite que la plus petite taille de caractéristique résoluble par ledit système de projection (PL) de sorte qu'une réflexion spéculaire à partir de ladite couche absorbante (22) est réduite, et **caractérisé en ce que** ladite texture comporte une grille de phase (23).

**12.** Procédé de fabrication d'un dispositif comportant les étapes consistant à :

- fournir un substrat (W) qui est au moins partiellement revêtu d'une couche de matériau sensible à un rayonnement ;

- fournir un faisceau de projection (PB) d'un rayonnement en utilisant un système de rayonnement ;

- utiliser des moyens de formation de motif pour doter le faisceau de projection (PB) d'un motif dans sa coupe transversale ;

- projeter le faisceau de rayonnement muni d'un motif sur une partie cible de la couche de matériau sensible à un rayonnement ; et

- absorber une partie dudit faisceau de projection (PB) dans une couche absorbante (22) fournie sur un élément optique, ladite couche absorbante (22) dudit élément optique étant munie d'une texture à une échelle plus petite que la plus petite taille de caractéristique résoluble par ledit système de projection (PL) de sorte qu'une réflexion spéculaire à partir de ladite couche absorbante (22) est réduite, et **caractérisé en ce que** ladite texture comporte une grille de phase (23).

## Fig. 1

Fig. 2

Fig. 3

Fig. 4

Fig. 5

## Fig. 6

S
- ▨ 0. 90-1.00
- ☐ 0. 80-0.90
- ⊞ 0. 70-0.80
- ▩ 0. 60-0.70
- ◨ 0. 50-0.60
- ▤ 0. 40-0.50
- ▥ 0. 30-0.40
- ▦ 0. 20-0.30
- ▩ 0. 10-0.20
- ■ 0. 00-0.10

## Fig. 7

## Fig. 8

## Fig. 9

Fig. 10

MB

Fig. 11

MB

Fig. 12

MB

Fig. 13

MA

Fig. 14

R-D

P-PL

PB-I

PB-R

MP

MA

30